(19) Europäisches Patentamt
European Patent Office
Office européen des brevets

(11) EP 0 803 912 A1

(12) # EUROPEAN PATENT APPLICATION

published in accordance with Art. 158(3) EPC

(43) Date of publication:
**29.10.1997 Bulletin 1997/44**

(21) Application number: **96937532.8**

(22) Date of filing: **07.11.1996**

(51) Int. Cl.$^6$: **H01L 29/812**, H01L 21/338

(86) International application number:
**PCT/JP96/03274**

(87) International publication number:
**WO 97/17731 (15.05.1997 Gazette 1997/21)**

(84) Designated Contracting States:
**DE FR GB NL**

(30) Priority: **09.11.1995 JP 291014/95**
**28.12.1995 JP 342834/95**

(71) Applicant:
**MATSUSHITA ELECTRONICS CORPORATION**
**Takatsuki-shi, Osaka 569 (JP)**

(72) Inventor: **TANABE, Mitsuru**
**Osaka 576 (JP)**

(74) Representative: **Kügele, Bernhard et al**
**NOVAPAT INTERNATIONAL SA,**
**9, Rue du Valais**
**1202 Genève (CH)**

(54) **FIELD EFFECT TRANSISTOR**

(57) In a field effect transistor **100**, an InAlAs buffer layer **11**, an InGaAs channel layer **12**, an InAlAs spacer layer **13**, an AlGaAs carrier supplying layer **14**, an InAlAs Schottky layer **15**, and an InGaAs cap layer **16** are provided on an InP substrate **10** in this order. Furthermore, a source electrode **17s**, a drain electrode **17d** and a gate electrode **18** are formed on the layered structure at prescribed positions. The carrier supplying layer **14** is made of a material that does not cause the silicon, contained therein as a dopant, to be terminated by fluorine. Thus, the field effect transistor **100** having a high transconductance can be formed without causing decrease in a drain current.

*FIG. 2*

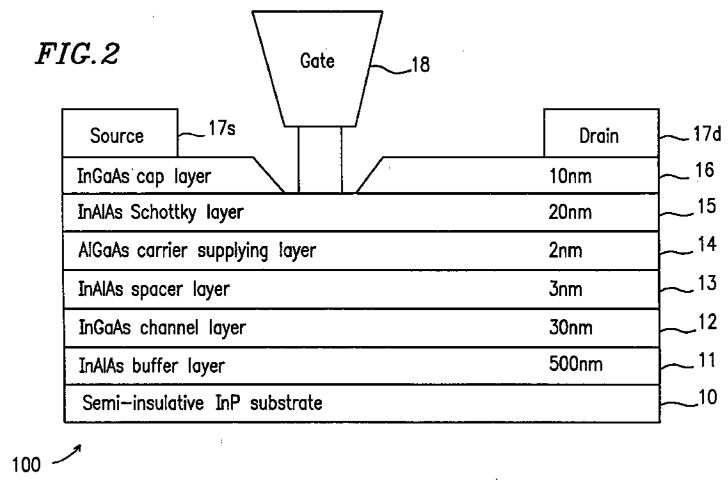


EP 0 803 912 A1

Printed by Rank Xerox (UK) Business Services
2.14.18/3.4

## Description

### TECHNICAL FIELD

The present invention relates to a field effect transistor (hereinafter, referred to as a "FET").

### BACKGROUND ART

An FET having an InAlAs/InGaAs type HEMT structure has been put into practice in a field of millimeter waves. Figure **1** is a cross-sectional view showing an FET **50** having an InAlAs/InGaAs type HEMT structure according to conventional technology.

In FET **50**, an undoped $In_{0.52}Al_{0.48}As$ buffer layer **2** having a thickness of about 500 nm, an undoped $In_{0.53}Ga_{0.47}As$ channel layer **3** having a thickness of about 30 nm, an undoped $In_{0.52}Al_{0.48}As$ spacer layer **4** having a thickness of about 3 nm, an n-type $In_{0.52}Al_{0.48}As$ Schottky layer **5** having a thickness of about 30 nm, and an n-type $In_{0.53}Ga_{0.47}As$ cap layer **7** (for example, doped with silicon) having a thickness of about 25 nm are provided on an Fe-doped InP substrate **1** in this order. Furthermore, a gate electrode and source/drain electrodes (not shown) are formed on the thus-obtained layered structure, thereby completing the FET **50**.

The n-type InAlAs Schottky layer **5** is doped with silicon which acts as an n-type dopant for supplying carriers (electrons) to the channel layer **3** via the spacer layer **4**. Silicon may be uniformly included in the entire InAlAs Schottky layer **5**. Alternatively, silicon doping may be realized by providing a silicon layer (a δ-dope layer) **6** on the order of several atomic layers between the InAlAs Schottky layer **5** and the InAlAs spacer layer **4**.

However, the FET **50** having the above-described structure has a problem of the electric characteristics of the InAlAs Schottky layer **5** deteriorating because of the heat treatment during the production process.

As to this point, according to the recent studies, it has become clear through experimentation that when fluorine (F) is attached to a surface of the InAlAs Schottky layer, the fluorine diffuses into the InAlAs Schottky layer during the subsequent heating process, ionizes, and bonds with dangling bonds of silicon contained in the InAlAs Schottky layer as an n-type dopant, thereby terminating (inactivating) the silicon that should act as a dopant (for example, see Technical Report of the Institute of Electronics, Information and Communication Engineers of Japan, ED 95-108 (October, 1995, pp. 35-40)). As a result, the carrier concentration and the mobility of the InGaAs channel layer **3** may be decreased, thereby causing deterioration of the electric characteristics of the transistor, such as a decrease in a drain current and variation in a threshold current.

However, such phenomenon is unique to InAlAs and cannot be seen in the case of InAs, AlAs, GaAs, AlGaAs or InGaAs.

Thus, in order to solve this problem, conventionally, fluorine is prevented from being mixed into the InAlAs Schottky layer by a method, for example, where an InAlGaAs layer is provided in the vicinity of the InAlAs Schottky layer so as to act as a barrier layer against fluorine (for example, see Technical Report of the Institute of Electronics, Information and Communication Engineers of Japan, ED 95-105 (October, 1995, pp. 13-20)).

However, as described above, when an InAlGaAs layer, as the barrier layer against fluorine, is formed in the vicinity of the InAlAs layer, a Schottky barrier between the InAlGaAs layer and the gate electrode becomes low, thereby causing a problem of a lowered gate breakdown voltage.

Thus, the present invention aims at providing an FET in which the effect of fluorine on the operational characteristics is minimized and which has excellent gate breakdown voltage characteristics.

### DISCLOSURE OF INVENTION

According to one aspect of the present invention, a field effect transistor is provided which includes a layered structure formed on a substrate, the layered structure including at least a channel layer. The layered structure further includes a carrier supplying layer containing a dopant for supplying carriers to the channel layer, and the carrier supplying layer is made of a material that is not affected by fluorine.

Preferably, the carrier supplying layer is made of a material that does not cause the dopant to be terminated by fluorine.

According to one embodiment, the carrier supplying layer is an $Al_xGa_{1-x}As$ layer ($0 \le x \le 1$). Alternatively, the carrier supplying layer is an $In_xGa_{1-x}As$ layer ($0 \le x \le 1$).

According to one embodiment, the dopant of the carrier supplying layer is uniformly included in the entire carrier supplying layer. The dopant may be silicon.

According to another embodiment, the carrier supplying layer includes a δ-dope layer where the dopant is deposited on the order of several atomic layers and a pair of semiconductor layers provided so as to sandwich the δ-dope layer. The dopant may be silicon.

According to another aspect of the present invention, a field effect transistor is provided which includes a layered structure having at least a Schottky layer and a channel layer on a substrate. The Schottky layer is an InAlAs layer and the channel layer is an InGaAs layer. The layered structure is provided with a carrier supplying layer containing a dopant for supplying carriers to the channel layer, the carrier supplying layer being made of a material that is not affected by fluorine.

Preferably, the carrier supplying layer is made of a material that does not cause the dopant to be terminated by fluorine.

According to one embodiment, the carrier supplying layer is an $Al_xGa_{1-x}As$ layer ($0 \le x \le 1$). Alternatively, the carrier supplying layer is an $In_xGa_{1-x}As$ layer ($0 \le x$

≤ 1).

According to one embodiment, the layered structure includes the InGaAs channel layer formed on the substrate, the carrier supplying layer formed on the InGaAs channel layer, and the InAlAs Schottky layer formed on the carrier supplying layer. The dopant of the carrier supplying layer is uniformly included in the entire carrier supplying layer. Under this circumstance, the layered structure may further include a spacer layer formed between the InGaAs channel layer and the carrier supplying layer. Furthermore, the dopant may be silicon.

According to another example, the layered structure includes the InGaAs channel layer formed on the substrate, the carrier supplying layer formed on the InGaAs channel layer, and the InAlAs Schottky layer formed on the carrier supplying layer. The carrier supplying layer includes a δ-dope layer where the dopant is deposited on the order of several atomic layers and a pair of semiconductor layers provided so as to sandwich the δ-dope layer. Under this circumstance, the layered structure may further include a spacer layer formed between the InGaAs channel layer and the carrier supplying layer. Moreover, the dopant may be silicon.

According to still another embodiment, the layered structure includes the carrier supplying layer formed on the substrate, the InGaAs channel layer formed on the carrier supplying layer, and the InAlAs Schottky layer formed on the InGaAs channel layer. In one circumstance, the dopant of the carrier supplying layer is uniformly included into the entire carrier supplying layer. Moreover, the dopant may be silicon. Alternatively, the carrier supplying layer includes a δ-dope layer where the dopant is deposited on the order of several atomic layers and a pair of semiconductor layers provided so as to sandwich the δ-dope layer. Moreover, the dopant may be silicon.

## BRIEF DESCRIPTION OF THE DRAWINGS

Figure **1** is a cross-sectional view showing a structure of an FET according to a conventional technology.

Figure **2** is a cross-sectional view showing a structure of an FET according to a first example of the present invention.

Figure **3** is a diagram schematically showing an energy band structure of the FET shown in Figure **2**.

Figure **4** is a diagram showing the essential part of the energy band structure of the FET shown in Figure **3** in more detail.

Figure **5** is a cross-sectional view showing a structure of an FET according to a second example of the present invention.

Figure **6** is a diagram schematically showing an energy band structure of the FET shown in Figure **5**.

Figure **7** is a cross-sectional view showing a structure of an FET according to a third example of the present invention.

Figure **8** is a cross-sectional view showing a structure of an FET according to a fourth example of the present invention.

Figure **9** is a diagram schematically showing an energy band structure of the FET shown in Figure **8**.

Figure **10(a)** is a cross-sectional view showing a structure of an evaluation sample corresponding to a device according to the present invention; and Figure **10(b)** is a cross-sectional view showing a structure of a comparative sample corresponding to a conventional device.

Figure **11(a)** is a graph showing the results of an SIMS analysis of the evaluation sample of Figure **10(a)**; and Figure **11(b)** is a graph showing the results of an SIMS analysis of the comparative sample of Figure **10(b)**.

Figure **12** is a graph showing measurement data of resistance characteristics against a fluorine solution of the evaluation sample of Figure **10(a)** and the comparative sample of Figure **10(b)**.

Figure **13** is a graph showing measurement data of thermal stability of the evaluation sample of Figure **10(a)** and the comparative sample of Figure **10(b)**.

Figure **14** is a graph showing measurement data of a cut-off frequency of an FET configured in accordance with the present invention, together with the measurement data that have been previously reported.

## BEST MODE FOR CARRYING OUT THE INVENTION

Hereinafter, various examples according to the present invention will be described with reference to the accompanying drawings.

### (Example 1)

Figure **2** is a cross-sectional view showing a heterojunction type FET **100** according to a first example of the present invention.

In the FET **100**, an undoped $In_{0.52}Al_{0.48}As$ buffer layer **11** having a thickness of about 500 nm, an undoped $In_{0.53}Ga_{0.47}As$ channel layer **12** having a thickness of 30 nm, an undoped $In_{0.52}Al_{0.48}As$ spacer layer **13** having a thickness of about 3 mm, an n-type $Al_{0.25}Ga_{0.75}As$ carrier supplying layer **14** having a thickness of about 2 nm, an undoped $In_{0.52}Al_{0.48}As$ Schottky layer **15** having a thickness of about 20 nm, and an n-type $In_{0.53}Ga_{0.47}As$ cap layer **16** (that is, for example, doped with silicon) having a thickness of about 10 nm are provided on an Fe-doped semi-insulative InP substrate **10** in this order. After the above-mentioned layers **11** through **16** are sequentially epitaxially grown on the substrate **10**, for example, by an MBE method, a resist pattern that masks a region where the FET will be formed is formed on the above-described layered structure by photolithography. Then, mesa separation is conducted by etching using, for example, a phosphorous type etchant such as a mixed solution of $H_3PO_4 : H_2O_2 : H_2O = 3 : 1 : 50$.

Next, a resist mask with openings at ohmic regions (i.e, regions where source/drain electrodes will be formed) is formed on the cap layer **16** by photolithography. Furthermore, an ohmic metal layer, for example, a metal layer having a multi-layered structure of Ni/AuGe/Au is deposited on the resist mask, and then lift-off is performed. By doing so, a source electrode **17s** and a drain electrode **17d** are formed at prescribed positions on the cap layer **16**. Herein, the thickness of each of the layers constituting the Ni/AuGe/Au multi-layered structure is set, for example, as follows: the Ni layer is about 2.5 nm thick, the AuGe layer is about 120 nm thick and the Au layer is about 60 nm thick.

Then, a lower resist layer (not shown) made of a material that is photosensitive to an electron beam (EB), such as PMMA, is formed so as to cover the cap layer **16** including the source electrode **17s** and the drain electrode **17d**. Further formed thereon is an upper resist layer (not shown) made of a material that is photosensitive to an electron beam (EB), such as P(MMA-CO-MAA).

Then, a slit-like opening pattern with a width of about 0.5 μm is formed in the upper resist layer (the P(MMA-CO-MAA) layer) by an electron beam radiation. Furthermore, the lower resist layer (the PMMA layer) is irradiated with an electron beam through the thus-formed slit-like opening pattern so as to form a slit-like opening pattern, for example, with a width of about 0.1 μm in the lower resist layer exposed in the opening pattern of the upper resist layer.

Moreover, a recessed structure is formed in the cap layer **16** by etching using, for example, a phosphorous type etchant such as a mixed solution of $H_3PO_4 : H_2O_2 : H_2O = 3 : 1 : 200$ while employing, as masks, the upper and the lower resist layers having the slit-like opening patterns formed as described above. The Schottky layer **15** is exposed at a bottom portion of the recess. Thereafter, a gate electrode constituted from a gate metal film, for example, a Ti/Pt/Au multi-layered structure, is subjected to deposition and lift-off so as to form a gate electrode **18** making contact with the Schottky layer **15** at the bottom portion of the recess. Herein, the thickness of each of the layers constituting the Ti/Pt/Au multi-layered structure is set, for example, as follows: each of the Ti layer and the Pt layer is about 50 nm thick and the Au layer is about 400 nm thick.

By further providing necessary wirings (not shown) on the thus-formed structure, the FET **100** is completed.

The carrier supplying layer **14** is made of an AlGaAs layer which is not affected by fluorine and is provided with an n-type conductivity by being supplied and doped with silicon during the crystal growth thereof. Accordingly, silicon is uniformly contained in the entire carrier supplying layer **14**.

Although the carrier supplying layer **14** is provided for supplying carriers (electrons) to the channel layer **12**, it is not provided in the channel layer **12** but above the channel layer **12** via the spacer layer **13**, i.e., on the Schottky layer side (but placed closer to the substrate than the Schottky layer **15**). By providing the spacer layer **13** between the carrier supplying layer **14** and the channel layer **12** in such a manner that the carrier supplying layer **14** and the channel layer **12** are separately positioned, scattering of the carriers running in the channel layer **12** due to ionized impurities contained in the carrier supplying layer **14** can be prevented in more effective manner. However, in the case where such a scattering of the running carriers does not cause any problem, the formation of the spacer layer **13** can be omitted.

Alternatively, the carrier supplying layer **14** can be formed in the channel layer **12**.

Figure **3** is a diagram schematically showing an energy band of the FET **100** having the structure shown in Figure **2**. Specifically, Figure **3** schematically shows lower ends of the conduction band of the substrate **10** and the respective layers **11** through **16** where a Fermi level $\varepsilon_F$ is drawn at the same level. Each of the reference numerals in Figure **3** denotes the layer denoted by the same reference numeral in the structure shown in Figure **2**.

On the other hand, Figure **4** is a diagram relative to the energy band diagram shown in Figure **3**, where the energy band ranging from the AlGaAs carrier supplying layer **14**, through the InAlAs spacer layer **13**, to the InGaAs channel layer **12** is shown in more detail. With reference to Figure **4**, the energy gap of $In_{0.53}Ga_{0.47}As$ channel layer **12** is $\Delta Eg = 0.75$ eV, the energy gap of the $In_{0.52}Al_{0.48}As$ spacer layer **13** is $\Delta Eg = 1.45$ eV and the energy gap of the n-type $Al_{0.25}Ga_{0.75}As$ carrier supplying layer **14** is $\Delta Eg = 1.75$ eV. Furthermore, the band offset between the carrier supplying layer **14** and the spacer layer **13** is $\Delta Ec = 0.08$ eV at the lower end of the conductive band and $\Delta Ev = 0.22$ eV at the upper end of the valence band. Similarly, the band offset between the spacer layer **13** and the channel layer **12** is $\Delta Ec = 0.52$ eV at the lower end of the conductive band and $\Delta Ev = 0.18$ eV at the upper end of the valence band.

In the above-described energy band structure, electrons are supplied from the n-type AlGaAs carrier supplying layer **14** through the spacer layer **13** to the channel layer **12** whereby the electrons run in the channel layer **12**. The carrier supplying layer **14**, which is made to be of an n-type by being doped with silicon, is made of AlGaAs which is not affected (terminated) by fluorine. Thus, the electrons can be efficiently supplied to the channel layer **12**.

Thus, according to the present invention, by constituting the carrier supplying layer **14** with an AlGaAs layer which is not affected by fluorine, the following can be prevented: diffusion of fluorine into the InAlAs layer and bonding with the silicon present therein that acts as an n-type dopant; decrease in sheet carrier density caused thereby; decrease in drain current density associated therewith. As a result, a highly reliable heterojunction type FET having an InAlAs/InGaAs structure with a high transconductance and stable operational characteristics against fluorine is provided without causing decrease in the drain current.

In the above description, the thickness of the AlGaAs layer used as the carrier supplying layer **14** is about 2 nm. This value is lower than the critical thickness (about 4 nm) determined based on mismatch of the lattice constant. Therefore, even when the AlGaAs layer (the carrier supplying layer) **14** is inserted in the InAlAs/InGaAs structure, dislocation due to lattice mismatch is not generated.

Moreover, in the above description, although the carrier supplying layer **14** is made of an AlGaAs layer, the constituting material thereof is not limited thereto. A Group III-V compound semiconductor, where no termination of silicon that acts as an n-type dopant is caused by fluorine, may be used as the constituting material of the carrier supplying layer. Specifically, instead of the above-described AlGaAs layer, the carrier supplying layer **14** may be made of a GaAs layer, an AlAs layer, an InAs layer or an InGaAs layer. Furthermore, the carrier supplying layer **14** may also be made of a material where P (phosphorous) is used as the Group V element, that is represented as an $In_xGa_{1-x}P$ layer ($0 \leq x \leq 1$) or an $Al_xGa_{1-xP}$ layer ($0 \leq x \leq 1$), specifically, an InP layer, a GaP layer, an AlP layer, an InGaP layer or an AlGaP layer. In particular, when the carrier supplying layer **14** is made of an InP layer, a lattice match can be obtained since it is made of the same material as the substrate. Moreover, when an InGaP layer is used, although the lattice constant is slightly greater than that of the InP, if the mole fraction of Ga is made to be about 20% ($In_{0.8}Ga_{0.2}P$), the critical thickness will lie in a greater range and the band gap of the channel layer **12** will be greater. Accordingly, carriers tend to localize in the channel layer **12**, and thus InGaP is suitable as a constituting material of the carrier supplying layer **14**.

Additionally, in the FET having the above-described structure, when the channel layer **12** is doped with an n-type dopant, the drain current becomes greater, thereby enabling for use as a power supply.

(Example 2)

Figure **5** is a cross-sectional view showing a heterojunction type FET **200** according to a second example of the present invention.

In FET **200**, a semi-insulative GaAs substrate **20** is used instead of the semi-insulative InP substrate used in the first example. In addition, in order to ease the lattice mismatch between the GaAs substrate **20** and an InAlAs/InGaAs type layered structure formed thereon, an undoped InGaAs graded buffer layer **21** having a thickness of about 1,000 nm is formed on the GaAs substrate **20**. The InGaAs graded buffer layer **21** is formed such that the mole fraction thereof gradually changes from the interface making contact with the GaAs substrate **20** to the interface making contact with the upper layered structure. Specifically, the mole fraction of the graded buffer layer **21** at the interface making contact with the GaAs substrate **20** is GaAs containing no In. As it goes upward starting therefrom, the amount of In content increases while the amount of Ga content decreases. At the interface making contact with the InAlAs buffer layer **11**, the mole fraction is $In_{0.53}Ga_{0.47}As$.

Furthermore, a layered structure which is substantially the same as that of the FET **100** according to the first example described with reference to Figure **2** is formed on the InGaAs graded buffer layer **21**. Specifically, an undoped $In_{0.52}Al_{0.48}As$ buffer layer **11** having a thickness of about 500 nm, an undoped $In_{0.53}Ga_{0.47}As$ channel layer **12** having a thickness of about 30 nm, an undoped $In_{0.52}Al_{0.48}As$ spacer layer **13** having a thickness of about 3 nm, an n-type $Al_{0.25}Ga_{0.75}As$ carrier supplying layer **14** having a thickness of about 2 nm, an undoped $In_{0.52}Al_{0.48}As$ Schottky layer **15** having a thickness of about 20 nm, and an n-type $In_{0.53}Ga_{0.47}As$ cap layer **16** (for example, doped with silicon) having a thickness of about 10 nm are provided in this order. Moreover, a source electrode **17s**, a drain electrode **17d** and a gate electrode **18** are formed in the same manner as shown in Figure **2**.

Each of the above-mentioned layers may be formed, for example, by an MBE method in the same way as in the first example. Also, the subsequent processes necessary for completing the FET may be the same as those described in the first example. In Figure **5**, components other than the substrate and the graded buffer layer are denoted by the same reference numerals as the corresponding components of FET **100** shown in Figure **2** and the detailed description thereof is omitted.

In the present example, the carrier supplying layer **14** is made of an AlGaAs layer which is not affected by fluorine and is provided with an n-type conductivity by being supplied and doped with silicon during the crystal growth thereof. Accordingly, silicon is uniformly contained in the entire carrier supplying layer **14**.

Although the carrier supplying layer **14** is provided for supplying carriers (electrons) to the channel layer **12**, it is not provided in the channel layer **12** but above the channel layer **12** via the spacer layer **13**, i.e., on the Schottky layer side (but placed closer to the substrate than the Schottky layer **15**). By providing the spacer layer **13** between the carrier supplying layer **14** and the channel layer **12** in such a manner that the carrier supplying layer **14** and the channel layer **12** are separately positioned, the scattering of the carriers running in the channel layer **12** due to ionized impurities contained in the carrier supplying layer **14** can be prevented in more effective manner. However, in the case where such a scattering of the running carriers does not cause any problem, the formation of the spacer layer **13** can be omitted.

Alternatively, the carrier supplying layer **14** can be formed in the channel layer **12**.

Figure **6** is a diagram schematically showing an energy band of the FET **200** having the structure shown in Figure **5**. Specifically, Figure **6** schematically shows lower ends of the conduction band of the substrate **20**, the graded buffer layer **21** and the respective layers **11** through **16** where a Fermi level $\varepsilon_F$ is drawn at the same level. Each of the reference numerals in Figure **6** denotes the layer denoted by the same reference numeral in the structure shown in Figure **5**.

In the above-described energy band structure, in the same manner as the first example of the present invention, electrons are supplied from the n-type AlGaAs carrier supplying layer **14** through the spacer layer **13** to the channel layer **12** whereby the electrons run in the channel layer **12**. The carrier supplying layer **14**, which is made to be of an n-type by being doped with silicon, is made of AlGaAs which is not affected (terminated) by fluorine. Thus, the electrons can be efficiently supplied to the channel layer **12**.

Thus, according to the present invention, by constituting the carrier supplying layer **14** with an AlGaAs layer which is not affected by fluorine, the following can be prevented: diffusion of fluorine into the InAlAs layer and bonding with the silicon present therein that acts as an n-type dopant; decrease in sheet carrier density caused thereby; decrease in drain current density associated therewith. As a result, a highly reliable heterojunction type FET having an InAlAs/InGaAs structure with a high transconductance and stable operational characteristics against fluorine is provided without causing decrease in the drain current.

The thickness of the AlGaAs layer used as the carrier supplying layer **14** is about 2 nm. This value is lower than the critical thickness (about 4 nm) determined based on mismatch of the lattice constant. Therefore, even when the AlGaAs layer (the carrier supplying layer) **14** is inserted in the InAlAs/InGaAs structure, dislocation due to lattice mismatch is not generated.

Moreover, in the above description, although the carrier supplying layer **14** is made of an AlGaAs layer, the constituting material is not limited thereto. A Group III-V compound semiconductor where no termination of silicon that acts as an n-type dopant is caused by fluorine may be used as the constituting material of the carrier supplying layer. Specifically, instead of the above-described AlGaAs layer, the carrier supplying layer **14** may be made of a GaAs layer, an AlAs layer, an InAs layer or an InGaAs layer. Furthermore, the carrier supplying layer **14** may also be made of a material where P (phosphorous) is used as the Group V element, that is represented as an $In_xGa_{1-x}P$ layer ($0 \le x \le 1$) or an $Al_xGa_{1-x}P$ layer ($0 \le x \le 1$), specifically, an InP layer, a GaP layer, an AlP layer, an InGaP layer or an AlGaP layer. In particular, in the case where an InGaP layer is used as the carrier supplying layer **14**, although the lattice constant is slightly greater than that of the InP, if the mole fraction of Ga is made to be about 20% ($In_{0.8}Ga_{0.2}P$), the critical thickness will lie in a greater range and the band gap of the channel layer **12** will be greater. Accordingly, carriers tend to localize in the channel layer **12**, and thus InGaP is suitable as a constituting material of the carrier supplying layer **14**.

Additionally, in the FET having the above-described structure, when the channel layer **12** is doped with an n-type dopant, the drain current becomes greater, thereby enabling for use as a power supply.

(Example 3)

Figure **7** is a cross-sectional view showing a heterojunction type FET **300** according to a third example of the present invention. Specifically, the FET **300** according to the present example has a so-called inverted HEMT structure.

In FET **300**, an undoped $In_{0.52}Al_{0.48}As$ buffer layer **11** having a thickness of about 500 nm, an n-type $Al_{0.25}Ga_{0.75}As$ carrier supplying layer **34** having a thickness of about 2 nm, an undoped $In_{0.52}Al_{0.48}As$ spacer layer **33** having a thickness of about 3 nm, an undoped $In_{0.53}Ga_{0.47}As$ channel layer **32** having a thickness of about 30 nm, an undoped $In_{0.52}Al_{0.48}As$ Schottky layer **15** having a thickness of about 20 nm, and an n-type $In_{0.53}Ga_{0.47}As$ cap layer **16** (for example, doped with silicon) having a thickness of about 10 nm are provided on an Fe-doped semi-insulative InP substrate **10** in this order. Furthermore, a source electrode **17s**, a drain electrode **17d** and a gate electrode **18** are formed on this layered structure as shown in Figure **2** or Figure **5**.

Each of the above-mentioned layers may be formed, for example, by an MBE method as in the first or the second example. Also, the subsequent processes necessary for completing the FET may be the same as those described in the first or the second example. In Figure **7**, the carrier supplying layer **34**, the spacer layer **33** and the channel layer **32**, which are formed at positions different from those of the FET **100** shown in Figure **2**, are denoted by different reference numerals. Components other than those are denoted by the same reference numerals as the corresponding components of the FET **100** shown in Figure **2** and the detailed description thereof is omitted.

In the present example, the carrier supplying layer **34** is made of an AlGaAs layer which is not affected by fluorine and is provided with an n-type conductivity by being supplied and doped with silicon during the crystal growth thereof. Accordingly, silicon is uniformly contained in the entire carrier supplying layer **34**.

Although the carrier supplying layer **34** is provided for supplying carriers (electrons) to the channel layer **32**, it is not provided in the channel layer **32** but below the channel layer **32** via the spacer layer **33**, i.e., on the substrate side (but placed closer to the Schottky layer side than the buffer layer **11**). By providing the spacer layer **33** between the carrier supplying layer **34** and the channel layer **32** in such a manner that the carrier supplying layer **34** and the channel layer **32** are separately positioned, the scattering of the carriers running in the channel layer **32** due to ionized impurities contained in the carrier supplying layer **34** can be prevented in more effective manner. However, in the case where such a scattering of the running carriers does not cause any problem, the formation of the spacer layer **33** can be omitted.

Thus, according to the present invention, by Constituting the carrier supplying layer **34** with an AlGaAs layer which is not affected by fluorine, the following can be prevented: diffusion of fluorine into the InAlAs layer and bonding with the silicon present therein that acts as an n-type dopant; decrease in sheet carrier density caused thereby; decrease in drain current density associated therewith. As a result, a highly reliable heterojunction type FET having an InAlAs/InGaAs structure with a high transconductance and stable operational characteristics against fluorine is provided without causing decrease in the drain current.

The thickness of the AlGaAs layer used as the carrier supplying layer **34** is about 2 nm. This value is lower than the critical thickness (about 4 nm) determined based on mismatch of the lattice constant. Therefore, even when the AlGaAs layer (the carrier supplying layer) **34** is inserted in the InAlAs/InGaAs structure, dislocation due to lattice mismatch is not generated.

Moreover, in the above description, although the carrier supplying layer **34** is made of an AlGaAs layer, the constituting material is not limited thereto. A Group III-V compound semiconductor where no termination of silicon that acts as an n-type dopant is caused by fluorine may be used as the constituting material of the carrier supplying layer. Specifically, instead of the above-described AlGaAs layer, the carrier supplying layer **34** may be made of a GaAs layer, an AlAs layer, an InAs layer or an InGaAs layer. Furthermore, the carrier supplying layer **34** may also be made of a material where P (phosphorous) is used as the Group V element, that is represented as an $In_xGa_{1-x}P$ layer ($0 \leq x \leq 1$) or an $Al_xGa_{1-x}P$ layer ($0 \leq x \leq 1$), specifically, an InP layer, a GaP layer, an AlP layer, an InGaP layer or an AlGaP layer. In particular, when the carrier supplying layer **34** is made of an InP layer, a lattice match can be obtained since it is made of the same material as the substrate **10**. Moreover, when an InGaP layer is used, although the lattice constant is slightly greater than that of the InP, if the mole fraction of Ga is made to be about 20% ($In_{0.8}Ga_{0.2}P$), the critical thickness will lie in a greater range and the band gap of the channel layer **32** will be greater. Accordingly, carriers tend to localize in the channel layer **32**, and thus InGaP is suitable as a constituting material of the carrier supplying layer **34**.

Additionally, in the FET having the above-described structure, when the channel layer **32** is doped with an n-type dopant, the drain current becomes greater, thereby enabling for use as a power supply.

(Example 4)

Figure **8** is a cross-sectional view showing a heterojunction type FET **400** according to a fourth example of the present invention.

The basic structure of the FET **400** according to the present example is the same as that of the FET **100** according to the first example shown in Figure **2**. However, although the FET **100** has been subjected to a so-called uniform doping where the n-type AlGaAs carrier supplying layer **14** is uniformly doped with silicon as an n-type dopant, the FET **400** according to the present example is supplied with an n-type dopant by providing a δ-dope layer **44d** in the AlGaAs carrier supplying layer **44**.

Herein, the δ-dope layer **44d** is formed by providing only several atomic layers, for example, only one atomic layer of silicon layer **44d** as an n-type dopant in the AlGaAs layer **44** that constitutes the carrier supplying layer **44**. For example, the thickness of the silicon layer **44d** is about 3 nm. On the other hand, each of an upper layer and a lower layer of the AlGaAs carrier supplying layer **44** sandwiching the δ-doped layer **44d** is about 1 nm and is in an undoped state. Thus, even when an extremely thin layer **44d** of an n-type dopant (in this case, silicon) is interposed between a pair of undoped AlGaAs layer (thickness: about 1 nm), the AlGaAs layer **44** acts as the carrier supplying layer.

Such a δ-doping described above is effective in enhancing the gain of the FET as compared to the uniform doping. Hereinafter, reasons for this will be described.

In order to enhance the gain of the FET, a slope $g_m$ ($= \partial I_{DS}/\partial V_{GS}$) of a drain current ($I_{DS}$) - gate voltage ($V_{GS}$) characteristic curve needs to be enhanced. In order to do so, the distance between the gate electrode and the channel layer immediately beneath the gate electrode needs to be decreased. However, in the structure according to the conventional technology, where the Schottky layer also serves to supply carriers, when the thickness of the Schottky layer is decreased as described above, the dose of dopant for supplying carriers to the channel layer decreases, thereby reducing the amount of carrier supplied to the carrier layer. From this stand-point, in order to prevent the decrease in the amount of supplied carrier while decreasing the thickness of the Schottky layer, the dose of dopant in the Schottky layer needs be increased so as to enhance the carrier supplying ability per unit volume. However, in such a case, on the other hand, the breakdown voltage characteristic of the Schottky layer against a voltage applied to the gate electrode may possibly be deteriorated.

Thus, in the case of the uniform doping, a trade-off relationship may exist between enhancing the gain and securing breakdown voltage against the gate voltage, making compatibility therebetween difficult.

On the other hand, in the case of δ-doping, it is only the δ-dope layer having a thickness of about several atomic layers that actually contains dopant in the structure constituting layers relative to supplying carriers. Accordingly, even when the thicknesses of the layers for supplying carriers are made small in order to enhance $g_m$, aiming at gain enhancement, no adverse effect of a decrease in the amount of carrier supply is caused. Thus, in the case of δ-doping, it is not necessary to increase the dose in order to compensate a decrease in the carrier supplying ability associated with the decrease in the thicknesses of the layers for supplying carriers, and thus, problem of deterioration of the breakdown voltage against the gate application voltage is not caused.

The FET **400** according to the present example is obtained by applying the δ-doping technique having the above-mentioned effect to the FET **100** shown in Figure **2**.

With reference to Figure **8**, an undoped $In_{0.52}Al_{0.48}As$ buffer layer **11** having a thickness of about 500 nm, an undoped $In_{0.53}Ga_{0.47}As$ channel layer **12** having a thickness of about 30 nm, an undoped $In_{0.52}Al_{0.48}As$ spacer layer **13** having a thickness of about 3 nm, a carrier supplying layer **44** constituting from a δ-dope layer **44d** and undoped $Al_{0.25}Ga_{0.75}As$ layers vertically sandwiching the δ-dope layer **44d** (thickness of each portion placed above and beneath the δ-dope layer **44d** is about 1 nm), an undoped $In_{0.52}Al_{0.48}As$ Schottky layer **15** having a thickness of about 30 nm, and an n-type $In_{0.53}Ga_{0.47}As$ cap layer **16** (for example, doped with silicon) having a thickness of about 5 nm are provided on the Fe-doped semi-insulative InP substrate **10** in this order. Furthermore, a source electrode **17s**, a drain electrode **17d** and a gate electrode **18** are formed on the layered structure in the same way as in the above-described examples.

The formation of each of the above-mentioned layers can be conducted, for example, by an MBE method as in the above-described examples. Moreover, the later processes necessary for completing the FET may be conducted in the same way as those described in the above examples. Herein, the δ-dope layer **44d** is formed by halting the Al and Ga supply and instead radiating silicon while continuing the radiation of As during the formation of the undoped AlGaAs layer. In Figure **8**, components other than the carrier supplying layer **44** including the δ-dope layer **44d** are denoted by the same reference numerals as the corresponding components in the above-described examples and the detailed description thereof is omitted.

Figure **9** is a diagram showing an energy band of the FET **400** having the structure shown in Figure **8**. Specifically, Figure **9** schematically shows lower ends of the conduction band of the substrate **10** and the respective layers **11** through **16**, and **44** where a Fermi level $\varepsilon_F$ is drawn at the same level. Each of the reference numerals in Figure **9** denotes the layer denoted by the same reference numeral in the structure shown in Figure **8**.

In the above-described energy band structure, electrons are supplied from the δ-dope layer **44d** included in the n-type AlGaAs carrier supplying layer **44** through the spacer layer **13** to the channel layer **12** whereby the electrons run in the channel layer **12**. Since the carrier supplying layer **44** is made of AlGaAs which is not affected (terminated) by fluorine. Thus, the electrons can be efficiently supplied to the channel layer **12**.

The values such as an energy gap $\Delta Eg$, a band offset $\Delta Ec$ at the lower end of the conduction band and a band offset $\Delta Ev$ at the upper end of the valence band are the same as those described in the first example with reference to Figure **4**.

Thus, even in the δ-doping structure according to the present example, by constituting the carrier supplying layer **44** with an AlGaAs layer which is not affected by fluorine, the following can be prevented: diffusion of fluorine into the InAlAs layer and bonding with the silicon present therein that acts as an n-type dopant; decrease in sheet carrier density caused thereby; decrease in drain current density associated therewith. As a result, a highly reliable heterojunction type FET having an InAlAs/InGaAs structure with a high transconductance and stable operational characteristics against fluorine is provided without causing decrease in the drain current.

In the carrier supplying layer **44**, the thickness of each undoped AlGaAs layer placed above and beneath the δ-dope layer **44d** is about 1 nm. This value is lower than the critical thickness (about 4 nm) determined based on mismatch of the lattice constant. Therefore, even when the AlGaAs layer (the carrier supplying layer) **44** is inserted in the InAlAs/InGaAs structure, dislocation due to lattice mismatch is not caused.

Furthermore, although the carrier supplying layer **44** is made of an AlGaAs layer in the above description, the constituting material is not limited thereto. A group III-V compound semiconductor in which silicon as an n-type dopant is not terminated by fluorine can be used as the constituting material for the carrier supplying layer. Specifically, instead of the AlGaAs layer described above, the carrier supplying layer **44** can be made of a GaAs layer, an AlAs layer, an InAs layer or an InGaAs layer. Moreover, the carrier supplying layer **44** may also be made of a material where P (phosphorous) is used as the group V element, that is represented as an $In_xGa_{1-x}P$ layer ($0 \leq x \leq 1$) or an $Al_xGa_{1-x}P$ layer ($0 \leq x \leq 1$), specifically, an InP layer, a GaP layer, an AlP layer, an InGaP layer or an AlGaP layer. In particular, when the carrier supplying layer **44** is made of an InP layer, a lattice match can be obtained since the carrier supplying layer **44** is made of the same material as the substrate. Moreover, when an InGaP layer is used, although the lattice constant is slightly greater than that of the InP, if the mole fraction of Ga is made to be about 20% ($In_{0.8}Ga_{0.2}P$), the critical thickness will lie in a greater range and the band gap of the channel layer **12** will be greater. Accordingly, carriers tend to localize in the channel layer **12**, and thus InGaP is suitable as a constituting material of the carrier supplying layer **44**.

Additionally, in the FET having the above-described structure, when the channel layer **12** is doped with an n-type dopant, the drain current becomes greater, thereby enabling for use as a power supply.

Additionally, in the above description, a case where δ-doping is applied to the structure of the FET **100** described in the first example is illustrated. Alternatively, equal effects as those described above can also be obtained in the case where the δ-doping is applied to the FET **200** or the FET **300** according to the second or the third example.

In order to further clarify the effects according to the present invention, SIMS analysis was conducted by producing an evaluation sample having a structure shown in Figure **10(a)**.

Specifically, as shown in Figure **10(a)**, the evaluation sample **700** is formed by providing an InAlAs layer **720** having a thickness of about **200** nm, an undoped AlGaAs layer **730** having a thickness of about 2 nm which contains a monoatomic layer of silicon as a δ-dope layer **730d** (where undoped AlGaAs layers each having a thickness of about 1 nm exist above and beneath the δ-dope layer **730d**) and further an InAlAs layer **740** having a thickness of about 200 nm on an InP substrate **710**, for example, by an MBE method. This corresponds to the structure according to the fourth example of the present invention previously described with reference to Figure **8**. On the other hand, as a comparative sample **800** corresponding to a structure according to conventional technology, as shown in Figure **10(b)**, an InAlAs layer **820** having a thickness of about 200 nm, a monoatomic layer of silicon (δ-dope layer) **830** and further an InAlAs layer **840** having a thickness of about 200 nm are formed on an InP substrate **810**, for example, by an MBE method.

After these samples **700** and **800** were subjected to heat treatment in a nitrogen atmosphere at a temperature of about 450°C for about 15 minutes, SIMS analysis was conducted from the top surface to the depth of about 300 nm. Figure **11(a)** and **11(b)** show the obtained SIMS profiles.

Referring to the results of the analysis of the comparative sample **800** corresponding to the structure of the conventional technology (see Figure **11(b)**), a peak of fluorine (F) is present in such a manner that it overlaps a silicon peak that corresponds to the monoatomic layer of silicon (δ-dope layer) **830**. On the other hand, referring to the results of the analysis of the evaluation sample **700** corresponding to the structure of the present invention (see Figure **11(a)**), a peak of fluorine (F) does not exist where a silicon peak corresponding to the monoatomic layer of silicon (δ-dope layer) **730d** is present.

Accordingly, it can be understood that diffusion of fluorine caused by heat treatment can be suppressed by configuring the carrier supplying layer with an AlGaAs layer as in the present invention. As a result, no problem of inactivating silicon, which should act as an n-type dopant, due to the bonding between diffusing fluorine and the silicon is caused, thereby minimizing deterioration of the carrier concentration associated with the bonding between the fluorine and the silicon.

Figure **12** is a graph showing the resistance characteristics against fluorine.

Specifically, changes in sheet carrier concentrations with respect to lapse of time of the evaluation sample (corresponding to the structure of the present invention) **700** and the comparative sample (corresponding to the structure of the conventional technology) **800** having the structures shown in Figures **10(a)** and **10(b)** were measured by a Hall measurement while confining a fluorine (HF) solution (concentration: about 46%) and the samples **700** and **800** in the same container at room temperature. Herein, the sheet carrier concentration refers to the amount of carriers present in the channel layer.

In Figure **12**, symbol ○ represents the measurement data of the evaluation sample **700** corresponding to the device according to the present invention shown in Figure 10(a) and symbol ● represents the measurement data of the comparative sample **800** corresponding to the device according to the conventional technology shown in Figure **10(b)**.

From the figure, in the case of the evaluation sample **800** corresponding to the conventional technology, the sheet carrier concentration suddenly deteriorates after being exposed to the fluorine atmosphere for about 50 seconds. On the other hand, in the case of the evaluation sample **700** having the structure of the present invention, the deterioration of the sheet carrier concentration is insignificant even after about 200 seconds, indicating that resistance thereof is about 4 times greater than that obtained in the case of the conventional technology. Accordingly, it can be appreciated that the structure according to the present invention has excellent resistance against fluorine.

Figure **13** is a graph indicating thermal stability.

Specifically, the evaluation sample (corresponding to the structure of the present invention) **700** and the comparative sample (corresponding to the structure of the conventional technology) **800** having the structures shown in Figures **10(a)** and **10(b)** were subjected to heat treatment in a nitrogen atmosphere at a temperature of about 450°C for about 15 minutes in order to measure changes in sheet carrier concentrations before and after the heat treatment by a Hall measurement. In the figure, symbol ○ represents measurement data of the evaluation sample **700** corresponding to the device according to the present invention shown in Figure **10(a)** and symbol ● represents measurement data of the comparative sample **800** corresponding to the device according to the conventional technology shown in Figure **10(b)**. In the graph, shown is data normalized based on the measured value obtained prior to the heat treatment.

From the figure, in the case of the evaluation sample **800** corresponding to the conventional technology, the sheet carrier concentration is decreased by about 20% by heat treatment of about 15 minutes. On the other hand, in the case of the evaluation sample **700** having the structure of the present invention, such a decrease in the carrier concentration is not caused. This is considered to be the result of the bonding between the diffusing fluorine and the silicon as the n-type dopant being suppressed, confirming that the structure of the present invention had an excellent thermal stability.

Furthermore, Figure **14** shows measurement data of a cut-off frequency of an HEMT having the structure of FET **400** according to the fourth example described with reference to Figure **8** (where the gate length **Lg** = 0. 5 μm). In Figure **14**, measurement data of InAlAs/InGaAs type HEMTs that have been reported so far is also plotted for comparison.

From the figure, the measurement data of the device according to the present invention exists on an extrapolation line of the cut-off frequency data of the devices that have been reported so far, confirming that the device according to the present invention had excellent characteristics that stood comparison with the devices according to the conventional technology.

The thicknesses and the mole fractions of each of the layers included in the structure of each example according to the present invention are not limited to the values specifically referred to in the above description, and changes can be made. Moreover, the constituting material of the source/drain electrodes or the gate electrode is not limited to the Ni/AuGe/Au multi-layered structure or the Ti/Pt/Au multi-layered structure specifically referred in the above description, and other materials can also be used. Furthermore, although, for example, the MBE method is referred to as a method for forming the layered structure as the method for producing the structure of the present invention, the present invention is not limited to a particular method. Any methods that are generally used in the art are usable.

INDUSTRIAL APPLICABILITY

As described above, according to the present invention, since a carrier supplying layer is made by using a group III-V compound semiconductor layer which is not affected by fluorine, termination of dopant caused by fluorine is suppressed, a drain current is not decreased, and high transconductance is maintained. As a result, a highly reliable FET is realized.

## Claims

**1.** A field effect transistor comprising a layered structure formed on a substrate, the layered structure including at least a channel layer, wherein

the layered structure further includes a carrier supplying layer containing a dopant for supplying carriers to the channel layer, and the carrier supplying layer is made of a material that is not affected by fluorine (where the dopant is not terminated by fluorine).

**2.** A field effect transistor according to claim 1, wherein the carrier supplying layer is made of a material that does not cause the dopant to be terminated by fluorine.

**3.** A field effect transistor according to claim 1, wherein the carrier supplying layer is an $Al_xGa_{1-x}As$ layer ($0 \leq x \leq 1$).

**4.** A field effect transistor according to claim 1, wherein the carrier supplying layer is an $In_xGa_{1-x}As$ layer ($0 \leq x \leq 1$).

**5.** A field effect transistor according to claim 1, wherein the dopant of the carrier supplying layer is uniformly included in the entire carrier supplying layer.

**6.** A field effect transistor according to claim 5, wherein the dopant is silicon.

**7.** A field effect transistor according to claim 1, wherein the carrier supplying layer comprises a δ-dope layer where the dopant is deposited on the order of several atomic layers, and a pair of semiconductor layers provided so as to sandwich the δ-dope layer.

**8.** A field effect transistor according to claim 7, wherein the dopant is silicon.

**9.** A field effect transistor, comprising a layered structure which includes at least a Schottky layer and a channel layer on a substrate, wherein

the Schottky layer is an InAlAs layer and the channel layer is an InGaAs layer, and

the layered structure is provided with a carrier supplying layer containing a dopant for supplying carriers to the channel layer, the carrier supplying layer being made of a material that is not affected by fluorine.

**10.** A field effect transistor according to claim 9, wherein the carrier supplying layer is made of a material that does not cause the dopant to be terminated by fluorine.

**11.** A field effect transistor according to claim 9, wherein the carrier supplying layer is an $Al_xGa_{1-x}As$ layer ($0 \leq x \leq 1$).

**12.** A field effect transistor according to claim 9, wherein the carrier supplying layer is an $In_xGa_{1-x}As$ layer ($0 \leq x \leq 1$ ).

**13.** A field effect transistor according to claim 9, wherein the layered structure comprises:

the InGaAs channel layer formed on the substrate;
the carrier supplying layer formed on the InGaAs channel layer; and
the InAlAs Schottky layer formed on the carrier supplying layer, and
the dopant of the carrier supplying layer is uniformly included in the entire carrier supplying layer.

**14.** A field effect transistor according to claim 13, wherein the layered structure further comprises a spacer layer formed between the InGaAs channel layer and the carrier supplying layer.

**15.** A field effect transistor according to claim 14, wherein the dopant is silicon.

**16.** A field effect transistor according to claim 9, wherein the layered structure comprises:

the InGaAs channel layer formed on the substrate;
the carrier supplying layer formed on the InGaAs channel layer; and
the InAlAs Schottky layer formed on the carrier supplying layer, and
the carrier supplying layer comprises a δ-dope layer where the dopant is deposited on the order of several atomic layers, and a pair of semiconductor layers provided so as to sandwich the δ-dope layer.

**17.** A field effect transistor according to claim 16, wherein the layered structure further comprises a spacer layer formed between the InGaAs channel layer and the carrier supplying layer.

**18.** A field effect transistor according to claim 17, wherein the dopant is silicon.

**19.** A field effect transistor according to claim 9, wherein the layered structure comprises:

the carrier supplying layer formed on the substrate;
the InGaAs channel layer formed on the carrier supplying layer; and
the InAlAs Schottky layer formed on the InGaAs channel layer.

**20.** A field effect transistor according to claim 19, wherein the dopant of the carrier supplying layer is uniformly included in the entire carrier supplying layer.

**21.** A field effect transistor according to claim 20, wherein the dopant is silicon.

**22.** A field effect transistor according to claim 19, wherein the carrier supplying layer comprises a δ-dope layer where the dopant is deposited on the order of several atomic layers, and a pair of semiconductor layers provided so as to sandwich the δ-dope layer.

**23.** A field effect transistor according to claim 22, wherein the dopant is silicon.

FIG. 1

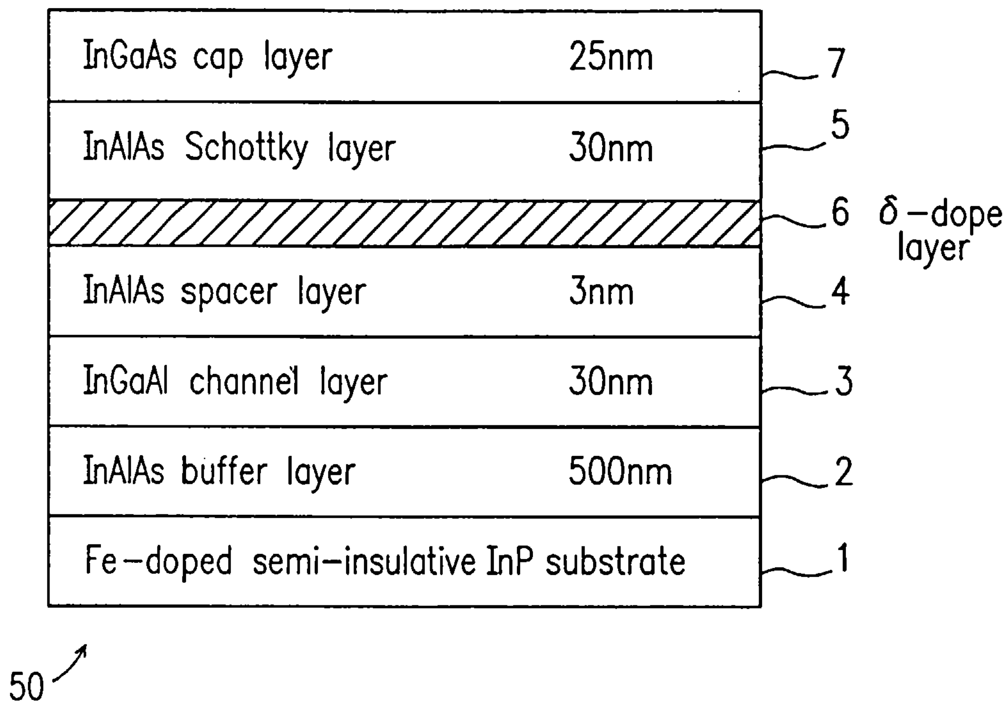

InGaAs cap layer 25nm
InAlAs Schottky layer 30nm
InAlAs spacer layer 3nm
InGaAl channel layer 30nm
InAlAs buffer layer 500nm
Fe-doped semi-insulative InP substrate
7
5
6
δ-dope layer
4
3
2
1
50

FIG.2

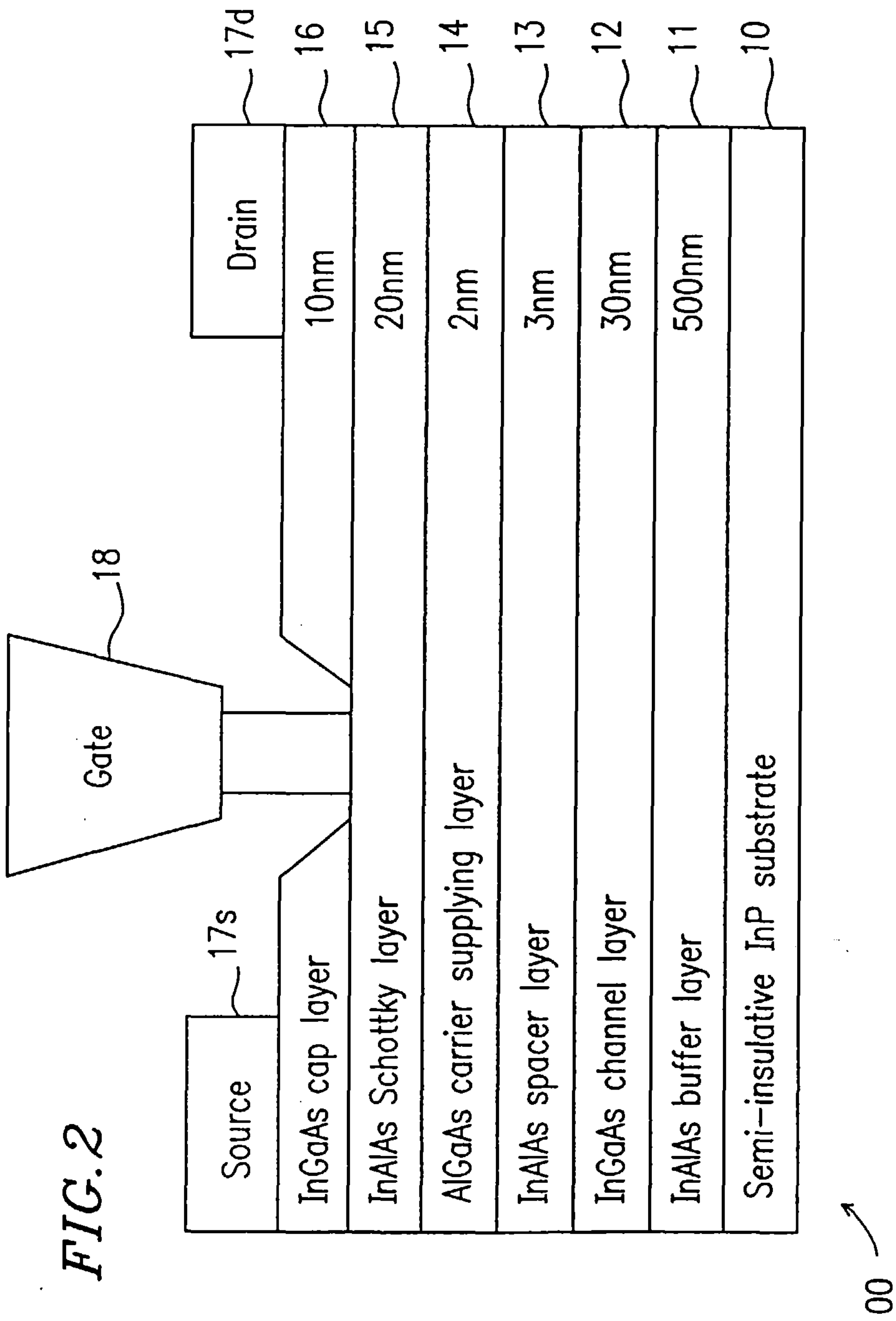
Gate
18
Source
17s
Drain
17d
InGaAs cap layer
10nm
16
InAlAs Schottky layer
20nm
15
AlGaAs carrier supplying layer
2nm
14
InAlAs spacer layer
3nm
13
InGaAs channel layer
30nm
12
InAlAs buffer layer
500nm
11
Semi-insulative InP substrate
10
100

*FIG.3*

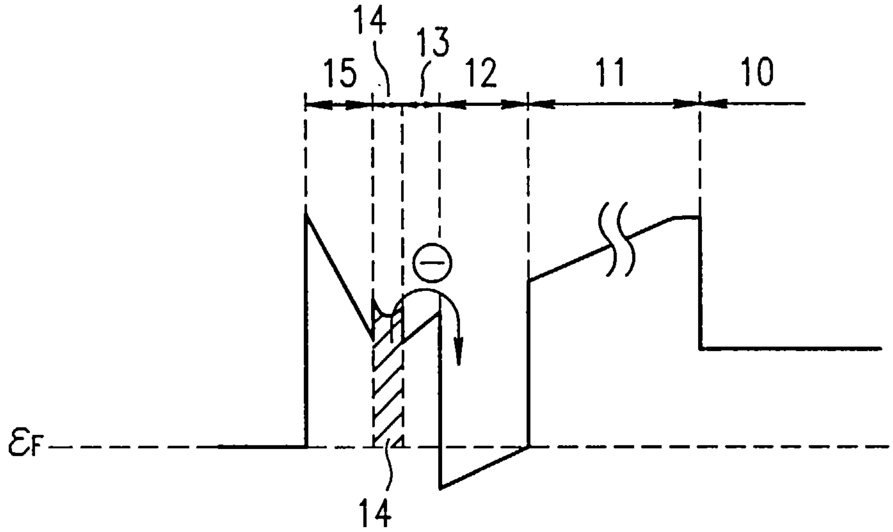


n–AlGaAs carrier supplying layer

*FIG. 4*

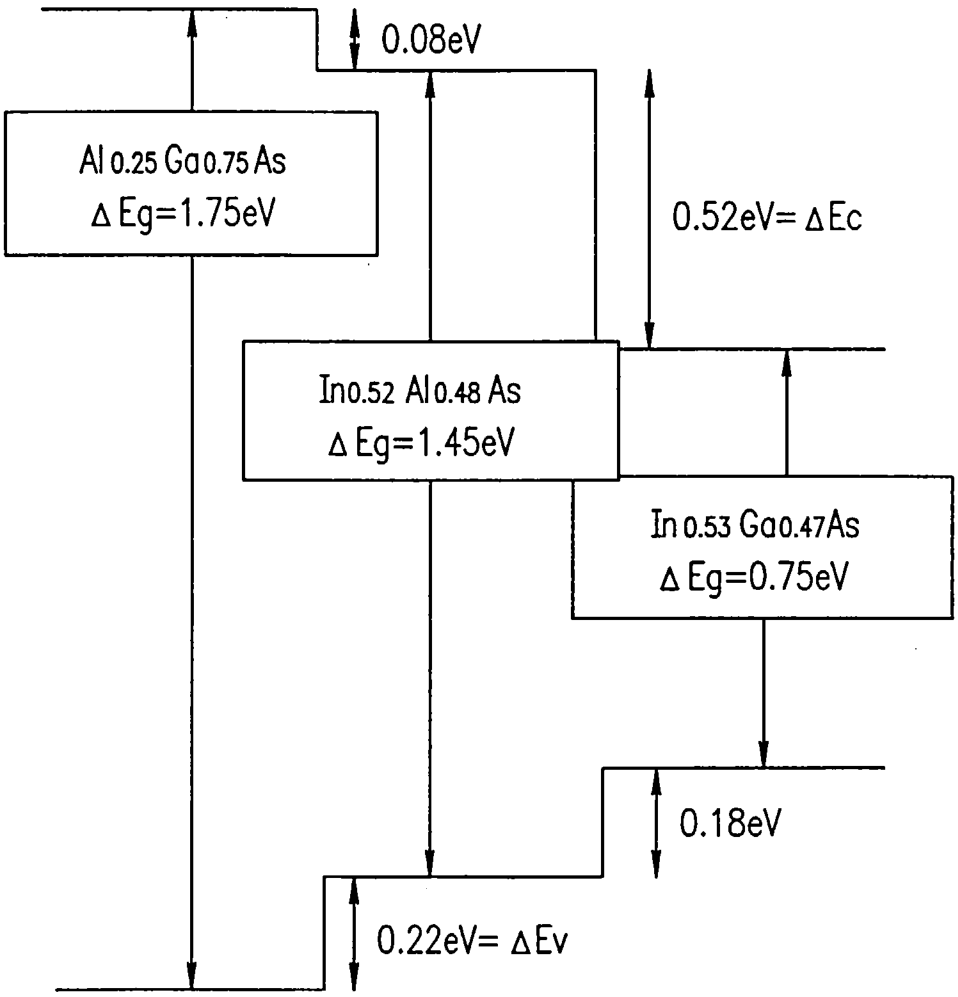
0.08eV
$Al_{0.25}Ga_{0.75}As$
$\Delta Eg=1.75eV$
$0.52eV=\Delta Ec$
$In_{0.52}Al_{0.48}As$
$\Delta Eg=1.45eV$
$In_{0.53}Ga_{0.47}As$
$\Delta Eg=0.75eV$
0.18eV
$0.22eV=\Delta Ev$

FIG. 5

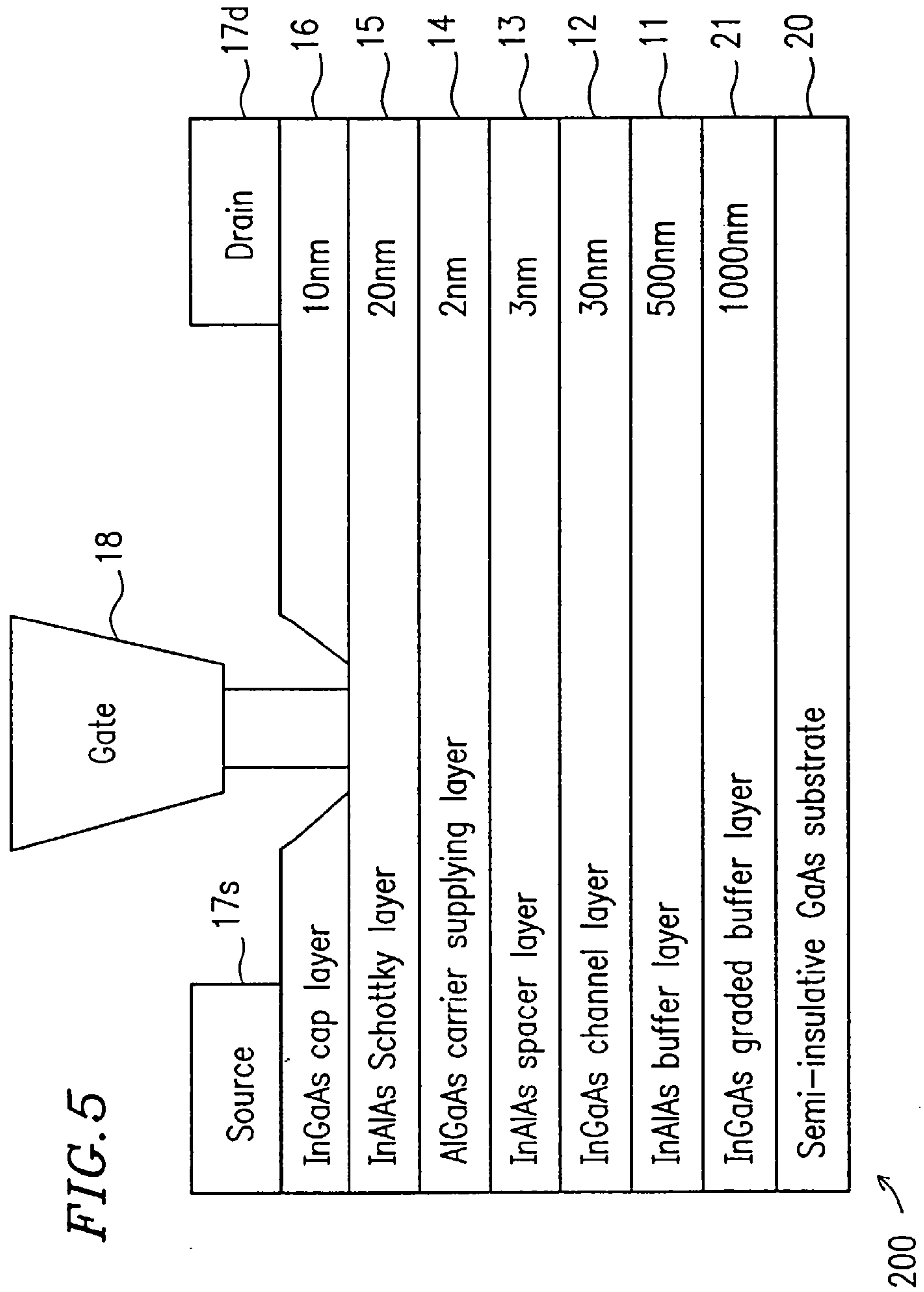
Gate
18
Source
17s
Drain
17d
InGaAs cap layer
10nm
16
InAlAs Schottky layer
20nm
15
AlGaAs carrier supplying layer
2nm
14
InAlAs spacer layer
3nm
13
InGaAs channel layer
30nm
12
InAlAs buffer layer
500nm
11
InGaAs graded buffer layer
1000nm
21
Semi-insulative GaAs substrate
20
200

*FIG. 6*

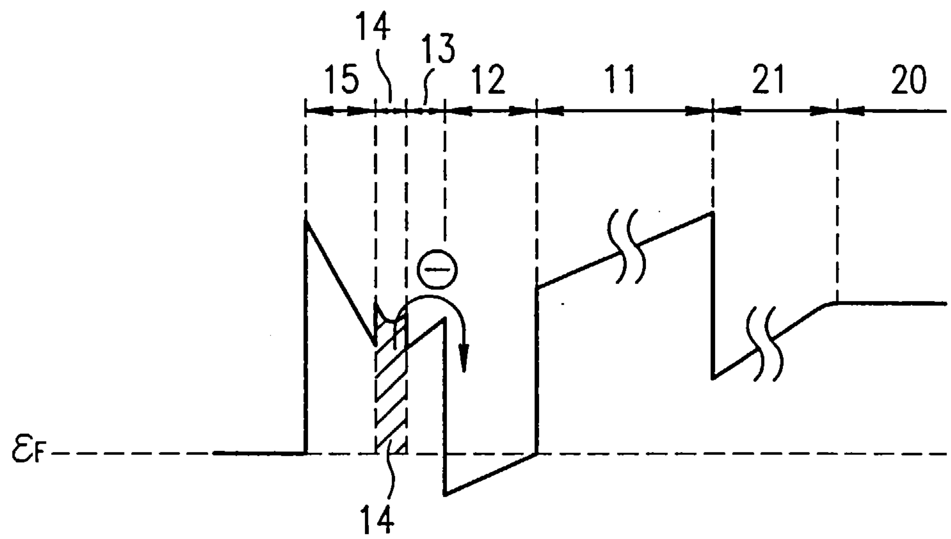


n–AlGaAs carrier supplying layer

FIG.7

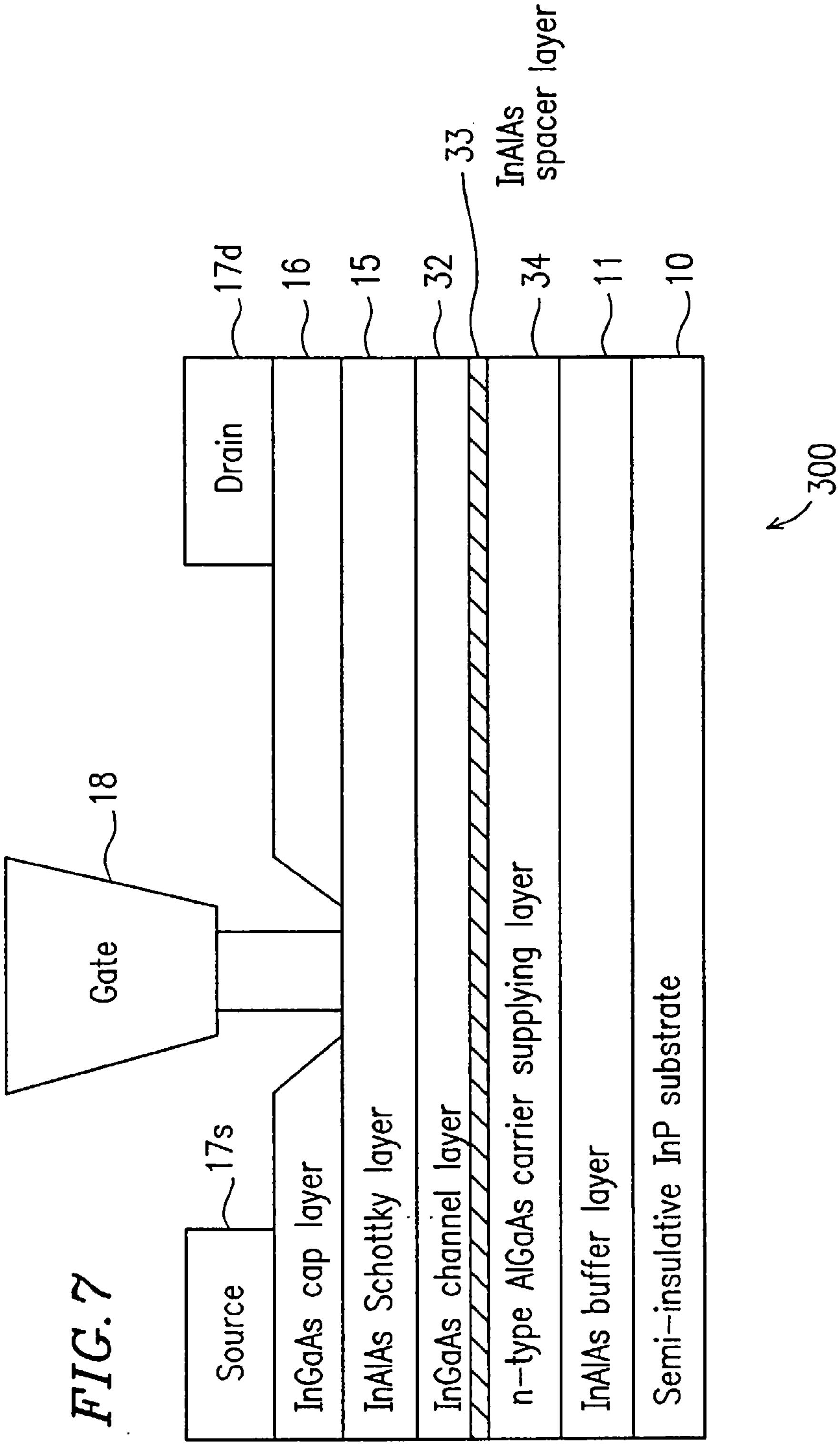
Source
17s
Gate
18
Drain
17d
InGaAs cap layer
16
InAlAs Schottky layer
15
InGaAs channel layer
32
33
InAlAs spacer layer
n-type AlGaAs carrier supplying layer
34
InAlAs buffer layer
11
Semi-insulative InP substrate
10
300

FIG.8

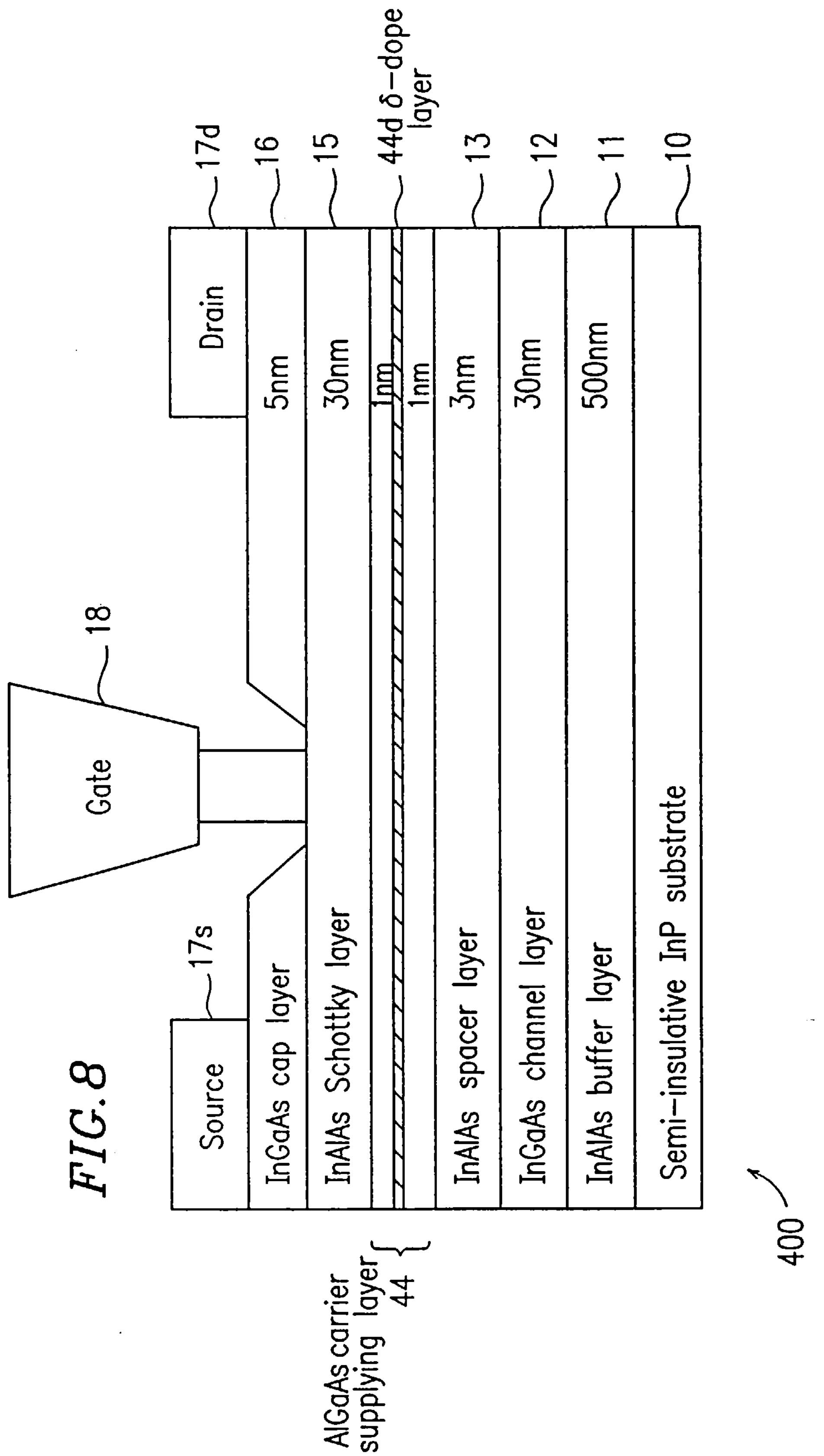
Source
17s
InGaAs cap layer
InAlAs Schottky layer
InAlAs spacer layer
InGaAs channel layer
InAlAs buffer layer
Semi-insulative InP substrate
AlGaAs carrier supplying layer 44
400
Gate
18
Drain
17d
16
15
44d δ−dope layer
13
12
11
10
5nm
30nm
1nm
1nm
3nm
30nm
500nm

*FIG. 9*

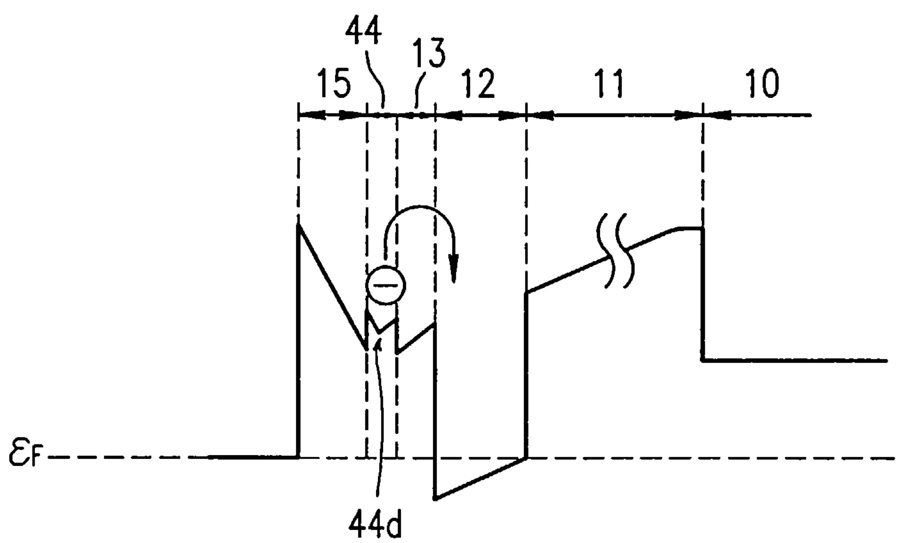

FIG. 10

(a)

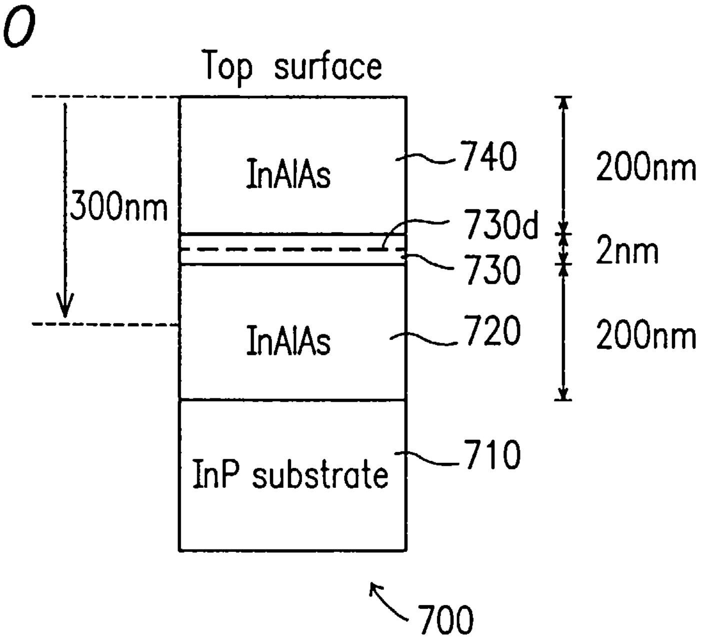
Top surface
300nm
InAlAs
740
730d
730
InAlAs
720
InP substrate
710
200nm
2nm
200nm
700

(b)

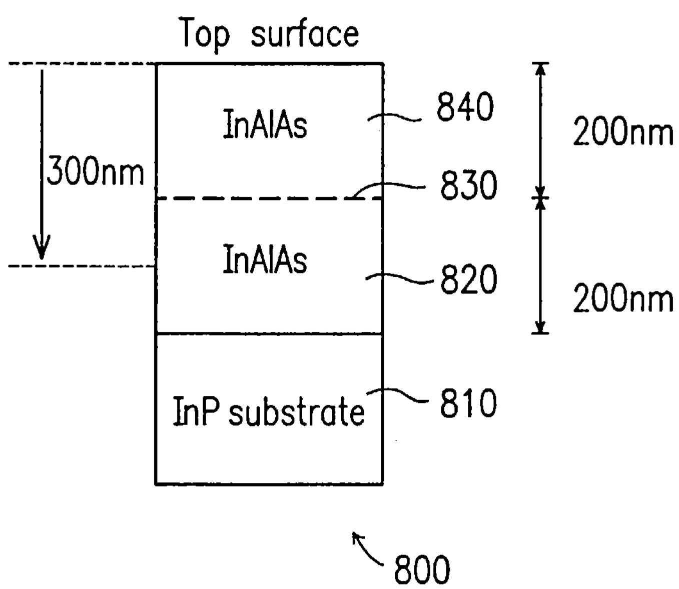
Top surface
300nm
InAlAs
840
830
InAlAs
820
InP substrate
810
200nm
200nm
800

*FIG. 11*

(a)

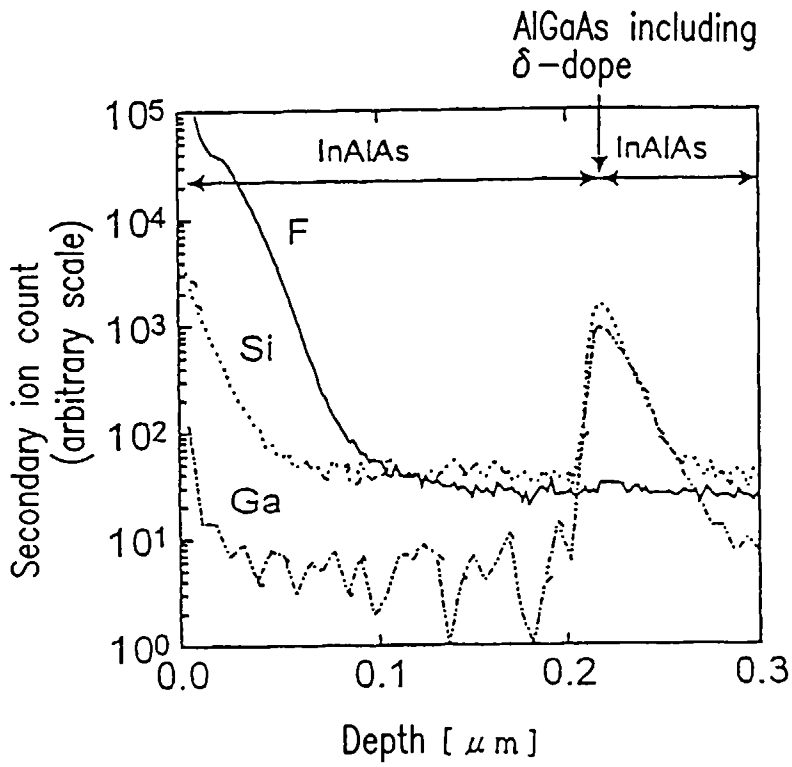
AlGaAs including
δ−dope
InAlAs
InAlAs
F
Si
Ga
Secondary ion count
(arbitrary scale)
10^5
10^4
10^3
10^2
10^1
10^0
0.0
0.1
0.2
0.3
Depth [μm]

(b)

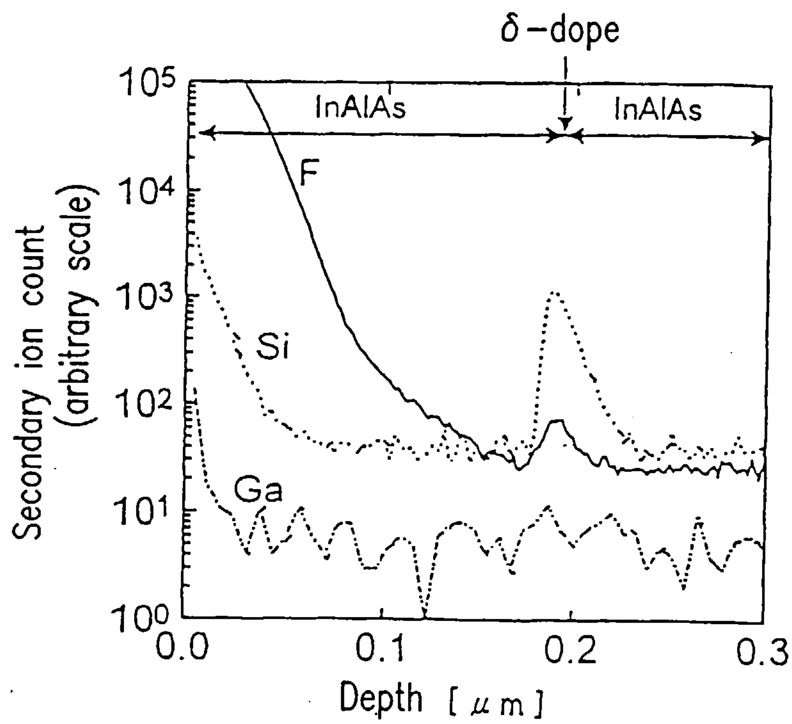
δ−dope
InAlAs
InAlAs
F
Si
Ga
Secondary ion count
(arbitrary scale)
10^5
10^4
10^3
10^2
10^1
10^0
0.0
0.1
0.2
0.3
Depth [μm]

*FIG. 12*

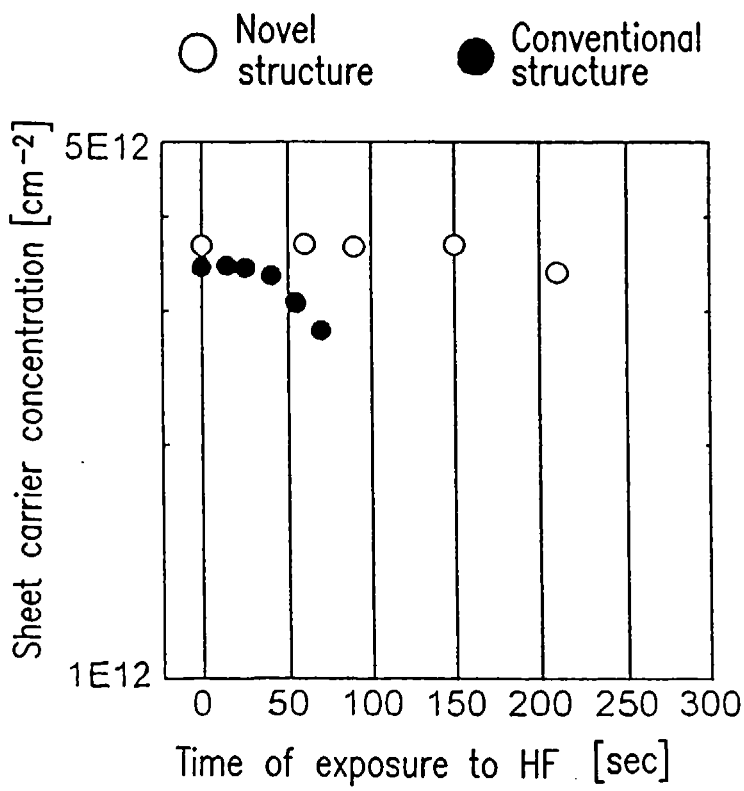
Novel structure
Conventional structure
Sheet carrier concentration [cm-2]
5E12
1E12
0
50
100
150
200
250
300
Time of exposure to HF [sec]

*FIG. 13*

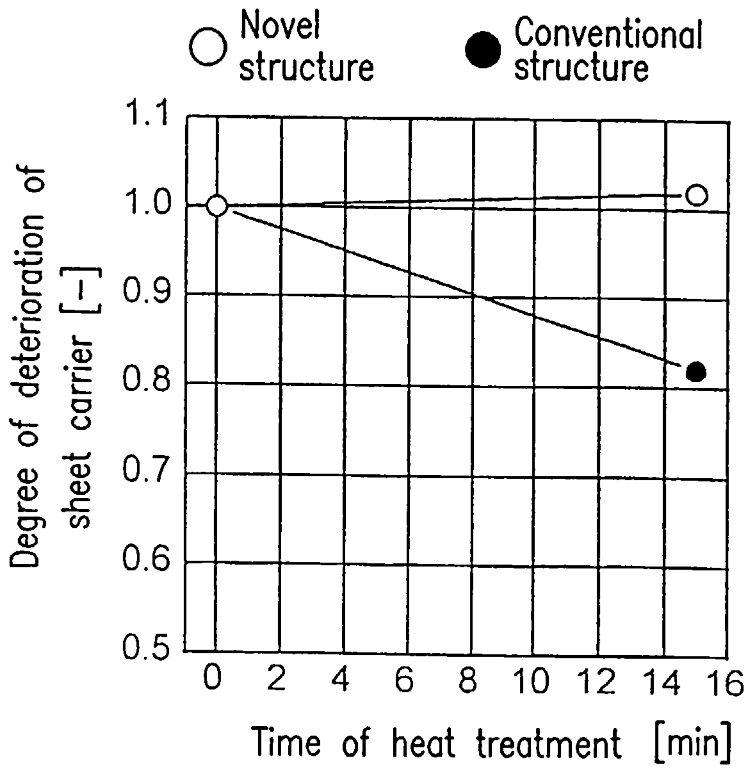
Novel structure
Conventional structure
Degree of deterioration of sheet carrier [–]
1.1
1.0
0.9
0.8
0.7
0.6
0.5
0
2
4
6
8
10
12
14
16
Time of heat treatment [min]

*FIG. 14*

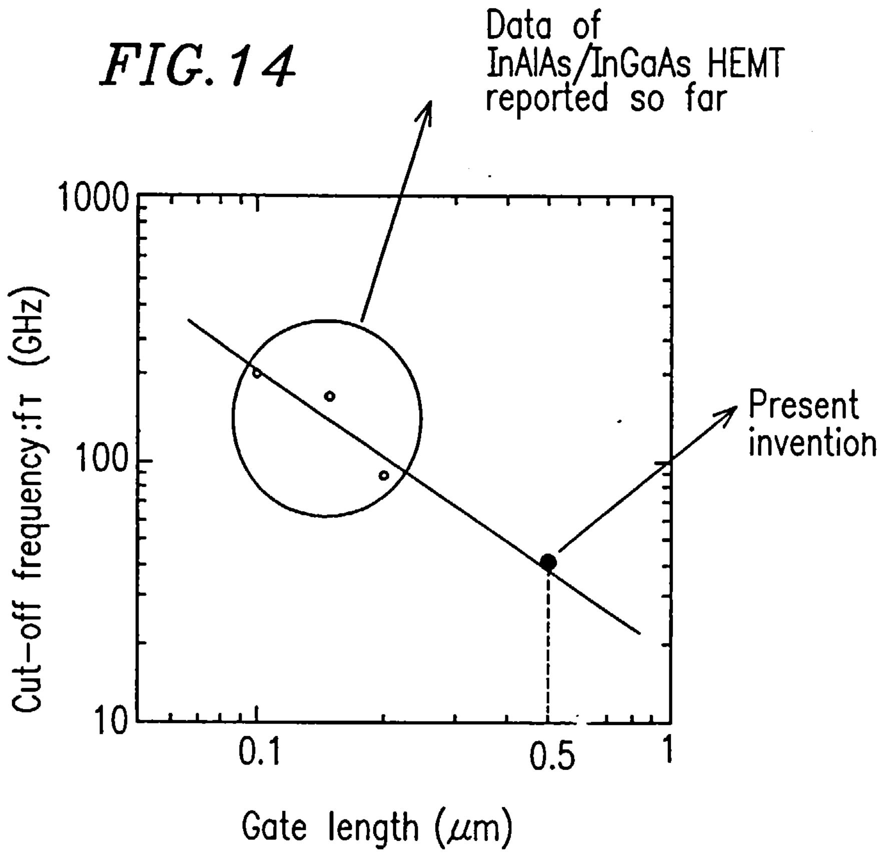
Data of
InAlAs/InGaAs HEMT
reported so far
1000
100
10
0.1
0.5
1
Cut-off frequency:fT (GHz)
Gate length (μm)
Present
invention

**INTERNATIONAL SEARCH REPORT**

International application No.
PCT/JP96/03274

**A. CLASSIFICATION OF SUBJECT MATTER**
Int. Cl[6] H01L29/812, H01L21/338

According to International Patent Classification (IPC) or to both national classification and IPC

**B. FIELDS SEARCHED**

Minimum documentation searched (classification system followed by classification symbols)
Int. Cl[6] H01L29/812, H01L21/338

Documentation searched other than minimum documentation to the extent that such documents are included in the fields searched
Jitsuyo Shinan Koho 1926 - 1995
Kokai Jitsuyo Shinan Koho 1971 - 1995

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | Denshi Joho Tsushin Gakkai Gijutsu Kenkyu Hokoku (IEICE Technical Report), Vol. 95, No. 315, (October 95), ED95-108, Norio Sato and three others "Dependence of InP series HEMT Material on a material non-activated by mixing with fluorine" P35-40, particularly, page 36, right column, line 34 to page 37, right column, line 20, table 1, Fig. 2; page 38, Fig. 3; page 40, lines 1 to 3, table 3 | 1-8, 9-23 |
| Y | Denshi Joho Tsushin Gakkai Gijutsu Kenkyu Hokoku (IEICE Technical Report), Vol. 95, No. 315 (October 95), ED95-105, Akira Fujihara and seven others "Heat stability of InAlAs/InGaAs series HJFET having a $In(Al_{1-x}Ga_x)As$ layer" P13-20, particularly, page 16, right column, line 8 to page 18, right column, line 6; Figs. 7-1 to 7-4 | 1-8, 9-23 |
| Y | JP, 5-226372, A (Hitachi, Ltd.), September 3, 1993 (03. 09. 93), | 3, 5, 6, 11, 13-15 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| February 17, 1997 (17. 02. 97) | March 4, 1997 (04. 03. 97) |
| Name and mailing address of the ISA/ Japanese Patent Office | Authorized officer |
| Facsimile No. | Telephone No. |

Form PCT/ISA/210 (second sheet) (July 1992)

**INTERNATIONAL SEARCH REPORT**

International application No.
PCT/JP96/03274

C (Continuation). DOCUMENTS CONSIDERED TO BE RELEVANT

| Category* | Citation of document, with indication, where appropriate, of the relevant passages | Relevant to claim No. |
|---|---|---|
| | Figs. 2, 6 (Family: none) | |
| Y | JP, 5-144849, A (Hitachi, Ltd.), June 11, 1993 (11. 06. 93), Figs. 1, 2, 5 (Family: none) | 1-6, 11-15 |
| Y | Planar doped layer 14; Fig. 5; paragraphs (0023) to (0026) | 7, 8, 16-23 |
| Y | JP, 63-107172, A (Sumitomo Electric Industries, Ltd.), May 12, 1988 (12. 05. 88), Fig. 1, EP, 264932, A1 & CA, 1261977, A1 & KR, 9008154, B1 | 9-12, 16-23 |
| Y | JP, 6-151468, A1 (Hitachi, Ltd.), May 31, 1994 (31. 05. 94), Figs. 1, 2, 3, 13 (Family: none) | 3, 5, 6, 11, 13-15 |
| Y | JP, 4-321239, A1 (Sanyo Electric Co., Ltd.), November 11, 1992 (11. 11. 92), Figs. 1, 3 (Family: none) | 3, 5, 6, 11, 13-15 |

Form PCT/ISA/210 (continuation of second sheet) (July 1992)